# EUROPÄISCHE PATENTANMELDUNG

(11) **EP 2 562 922 A1**
(43) Veröffentlichungstag der Anmeldung: **27.02.2013**
(21) Anmeldenummer: 11178965.7
(22) Anmeldetag: 26.08.2011
(51) Int. Cl.: H02M 7/00, H05K 7/20

(54) **Modular aufgebaute Stromrichteranordnung**

(71) Anmelder: SIEMENS AKTIENGESELLSCHAFT, 80333 München (DE)
(72) Erfinder: Weis, Benno, 91334 Hemhofen (DE)

(57) **Zusammenfassung**

Die Erfindung bezieht sich auf eine modular aufgebaute Stromrichteranordnung. Erfindungsgemäß weist diese modular aufgebaute Stromrichteranordnung (2) einen Kühlkörper (4), mit wenigstens einem Leistungshalbleitermodul (6), die thermisch und mechanisch mit dem Kühlkörper (4) verbunden sind, wenigstens einen Kondensator (12) eines Zwischenkreiskondensators, die mittels einer Verschienungs-Leiterplatte (10) untereinander elektrisch leitend verbunden sind, eine Ansteuerbaugruppe, bestehend aus Bauelementen wenigstens einer Ansteuerschaltung, die mittels einer Leiterplatte (8) untereinander elektrisch leitend verbunden sind, wobei die Kondensatoren (12) derart fluchtend in Strömungsrichtung eines Kühlkanals (24) dem Kühlkörper (4) nachgeordnet sind, dass die Verschienungs-Leiterplatte (10) direkt oberhalb der Leistungshalbleitermodule (6) angeordnet ist, und wobei die Leiterplatte (8) der Ansteuerbaugruppe oberhalb der Verschienungs-Leiterplatte (10) angeordnet ist, und deren Ausgänge mit Steuereingängen eines Leistungshalbleitermoduls (6) elektrisch leitend verbunden sind. Somit erhält man eine modular aufgebaute Stromrichteranordnung, die einerseits auftretende Überspannungen amplitudenmäßig verringert und andererseits die Störfestigkeit seiner Ansteuerschaltung wesentlich erhöht.

## Beschreibung

Die Erfindung bezieht sich auf eine modular aufgebaute Stromrichteranordnung mit einem Kühlkörper, wenigstens einem Leistungshalbleitermodul, wenigstens einem Kondensator eines Zwischenkreis-Kondensators, einer Ansteuerbaugruppe und einer Verschienungs-Leiterplatte.

In FIG 11 der Veröffentlichung "A new 690V AC drive integrated sine wave output filter and SiC Schottky freewheeling diodes" von Benno Weis, Martin Wölz und Dethard Peters, veröffentlicht im Konferenzband der SPS/IPC/DRIVES 2006 in Nürnberg, ist ein Schnitt durch das Gehäuse eines Frequenzumrichters dargestellt, so dass der mechanische Aufbau dieses Frequenzumrichters erkennbar ist. Die Basiseinheit dieses Frequenzumrichters ist ein Kühlkörper, auf dem wenigstens ein Leistungshalbleitermodul, insbesondere ein IGBT-Sixpack-Modul, mechanisch befestigt ist. Dieses Leistungshalbleitermodul ist thermisch gut leitend mit dem Kühlkörper verbunden. Auf diesem Leistungshalbleitermodul ist eine Leiterplatte einer Ansteuerbaugruppe angeordnet und mit Steueranschlüssen des Leistungshalbleitermoduls elektrisch leitend verbunden. Diese Ansteuerbaugruppe umfasst alle Bauelemente wenigstens einer Ansteuerschaltung. Oberhalb dieser Leiterplatte ist eine Verschienungs-Leiterplatte beabstandet angeordnet, die eine Vielzahl von Kondensatoren aufweist. Diese Kondensatoren sind elektrisch in Reihe und/oder parallel geschaltet und bilden einen Zwischenkreis-Kondensator des Frequenzumrichters. Außerdem weist diese Verschienungs-Leiterplatte jeweils eine Lage aus elektrisch leitendem Material, beispielsweise Kupfer, für jeweils eine Gleichspannungsschiene und eine Wechselspannungsschiene auf. Diese Lagen der Verschienungs-Leiterplatte müssen mit entsprechenden Leistungsanschlüssen des Leistungshalbleitermoduls elektrisch leitend verbunden werden. Dazu werden Hochstromkontakte verwendet. Bei diesem dargestellten Frequenzumrichter handelt es sich um einen zwangsgekühlten Umrichter. Dazu weist dieser zwei Lüfter auf, die an einer Stirnseite, nämlich der Kühlmitteleintrittsseite des Kühlkörpers, angebracht sind. Auf der Kühlmittelaustrittsseite des Kühlkörpers ist eine Drossel eines Sinus-Ausgangsfilters angeordnet. Dadurch wird diese Drossel ebenfalls gekühlt.

Um Überspannungen beim Abschalten eines Leistungshalbleiters in einem Frequenzumrichter zu minimieren, ist es erforderlich, den Kommutierungskreis des Umrichters möglichst niederinduktiv auszuführen. Der Kommutierungskreis besteht aus den an der Kommutierung beteiligten Leistungshalbleitern, dem Zwischenkreis-Kondensator, der aus einer Vielzahl von Elektrolytkondensatoren aufgebaut ist, und den Gleichspannungsschienenstücken, die die an der Kommutierung beteiligten Leistungshalbleitern mit dem Zwischenkreis-Kondensator elektrisch leitend verbinden. Für einen niederinduktiven Aufbau ist es wichtig, die Kondensatoren möglichst nahe am Leistungshalbleitermodul anzuordnen. Zudem soll die Fläche minimiert sein, die die positive und negative Gleichspannungsschienenstücke vom Leistungshalbleitermodul zum Zwischenkreis-Kondensator aufspannen. Idealerweise wird dies dadurch erreicht, dass diese beiden Gleichspannungsschienen als verschiedene Lagen einer Leiterplatte ausgeführt werden.

Außerdem müssen zum Zwecke der Störfestigkeit der Ansteuerschaltung die Wege der Ansteuersignale möglichst kurz sein. Dies wird dadurch erreicht, dass die Ansteuerbaugruppe möglichst nahe am Leistungshalbleitermodul angeordnet wird.

Da bei dem Frequenzumrichter der Veröffentlichung SPS/IPC/DRIVES 2006 die Verbindung von den Leistungsanschlüssen des Leistungshalbleitermoduls zu den Stromschienen der Verschienungs-Leiterplatte mittels Hochstromkontakten ausgeführt wird, wird eine verhältnismäßig große Induktivität in den Kommutierungskreis eingebracht. Außerdem ist diese Aufbautechnik des Frequenzumrichters nicht kompakt, da oberhalb der Verschienungs-Leiterplatte wegen der hohen Bauform der Kondensatoren viel Platz benötigt wird.

Um die Stromschienen der Verschienungs-Leiterplatte mittels der Hochstromkontakte mit den Leistungsanschlüssen des Leistungshalbleitermoduls elektrisch leitend zu verbinden, weist die Leiterplatte der Ansteuerbaugruppe neben Leiterbahnen für Schwachstrom auch solche für Starkstrom auf. Dadurch können die Ansteuerschaltungen gestört werden. Damit eine Leiterbahn einen hohen Strom führen kann, muss deren Kupferbelag beispielsweise eine Dicke von 105 µm aufweisen. Die Leiterbahnen, die den Schwachstrom führen, müssen einen Kupferbelag von beispielsweise nur 18 µm aufweisen. Da beide Leiterbahnen auf einer Leiterplatte realisiert werden sollen, muss bezüglich deren Dicken ein Kompromiss gefunden werden.

Aus der DE 10 2009 053 583 B3 ist eine modular aufgebaute Stromrichteranordnung bekannt, die ein Stromrichtermodul, einen Kühlkörper, eine Ansteuerbaugruppe, eine Vielzahl von Elektrolytkondensatoren und eine Verschienung aufweist. Das Stromrichtermodul ist thermisch und mechanisch mit dem Kühlkörper verbunden. Dieser Kühlkörper ist Teil einer Kühleinrichtung der Stromrichteranordnung, die noch zwei Lüfter aufweist. Dieser Kühlkörper ist derart in der modular aufgebauten Stromrichteranordnung angeordnet, dass neben diesem Kühlkörper noch ein Bereich für die Kondensatoren des Zwischenkreiskondensators vorhanden ist. Bei einer dreiphasigen Ausführungsform der modular aufgebauten Stromrichteranordnung sind drei gleichartige Leistungshalbleitermodule (Halbbrückenmodule) auf dem Kühlkörper angeordnet und mittels einer Verbindungseinrichtung schaltungsgerecht miteinander verbunden. Auf dieser Verbindungseinrichtung ist die Ansteuerbaugruppe der Leistungshalbleitermodule angeordnet und schaltungsgerecht und mit kurzen Leitungswegen mit Steueranschlüssen der Leistungshalbleitermodulen verbunden. Der Zwischenkreiskondensator selbst besteht aus zwei Kondensatorbänken. Die erste Kondensatorbank ist neben dem Kühlkörper angeordnet, wobei die einzelnen Kondensatoren mittels einer Leiterplatte mit der Verbindungseinrichtung der Leistungshalbleitermodule oder direkt mit den Leistungsmodulen niederinduktiv verbunden sind. Die zweite Kondensatorbank ist spiegelbildlich zu ersten Kondensatorbank angeordnet, wobei dann die jeweiligen Leiterplatten einander zugewandt sind.

Gegenüber der Aufbautechnik des Frequenzumrichters der Veröffentlichung SPS/IPC/DRIVES 2006 ist die der Stromrichteranordnung der DE 10 2009 053 583 B3 kompakter. Außerdem ist die Induktivität im Kommutierungskreis geringer, da keine Hochstromkontakte mehr verwendet werden müssen, sondern die Verschienung des Zwischenkreiskondensators mit der Verbindungseinrichtung der Leistungshalbleitermodule oder direkt mit den Leistungshalbleitermodulen verbunden ist.

Aus der eupec-Veröffentlichung "EconoPACK+ ― A new IGBT module for optimized inverter solutions" von M. Münzer und M. Hornkamp, veröffentlicht im August 2000, ist eine modular aufgebaute Stromrichteranordnung bekannt, die sehr kompakt ausgeführt ist. Diese Stromrichteranordnung weist einen Kühlkörper auf, der einerseits die Leistungshalbleitermodule und andererseits die Kondensatoren eines Zwischenkreiskondensators aufnimmt und kühlt. Mit der Hilfe einer Leiterplatte, allgemein als printed circuit board (PCB) bezeichnet, für die Leistungsverbindung, für die Verschaltung der Kondensatoren des Zwischenkreiskondensators und für die Ansteuerbaugruppe für die Leistungshalbleitermodule wäre dieser Aufbau sehr kompakt. Außerdem wird mittels dieser Aufbautechnik ein niederinduktiver Kommutierungskreis erreicht, weil dieser kompakt in der Leiterplatte verläuft. Dagegen können die Ansteuerschaltungen eines jeden Leistungshalbleitermoduls gestört werden, da die Schwachstrom- und Starkstromverschienung in einer Leiterplatte umgesetzt wird.

Der Erfindung liegt nun die Aufgabe zugrunde, die modular aufgebaute Stromrichteranordnung derart weiterzubilden, dass die eingangs genannten Nachteile nicht mehr auftreten.

Diese Aufgabe wird mit den Merkmalen des Anspruchs 1 erfindungsgemäß gelöst.

Durch die Trennung der Leistungs-Verschienung und der Signal-Verschienung und der Anordnung der Leistungs-Verschienung direkt auf den Leistungsanschlüssen des Leistungshalbleitermoduls bzw. der Leistungshalbleitermodule wird erreicht, dass der Kommutierungskreis einen sehr niederinduktiven Aufbau aufweist. Durch diese sehr niederinduktive Ausführungsform des Kommutierungskreises werden die Amplituden von Überspannungen beim Abschalten eines Leistungshalbleiters weiter reduziert. Außerdem wird durch die Trennung von Leistungs- und Signal-Verschienung erreicht, dass die Ansteuerschaltungen einer Ansteuerbaugruppe, die auf einer Leiterplatte mit der Signal-Verschienung angeordnet sind, nicht mehr gestört werden. Außerdem ist es nicht mehr erforderlich, einen Kompromiss bezüglich der Dicke des Kupferbelages der Leistungs- und Signal-Verschienung zu treffen, da diese beiden unterschiedlichen Verschienungen jeweils mittels einer Leiterplatte verwirklicht werden. Da die Kondensatoren des Zwischenkreiskondensators in Flucht der Strömungsrichtung eines Kühlmittels dem Kühlkörper räumlich nachgeordnet sind, kann die Leiterplatte mit den Ansteuerschaltungen einer Ansteuerbaugruppe und deren signaltechnischen Verbindung direkt oberhalb der Leistungs-Verschienung angebracht werden. Dadurch sind die Ansteuerschaltungen jeweils nahe an zugeordneten Leistungshalbleitern angeordnet. Somit erhöht sich deren Störfestigkeit.

Vorteilhafte Ausführungsformen der modular aufgebauten Stromrichteranordnung sind den Unteransprüchen 2 bis 11 zu entnehmen.

Zur weiteren Erläuterung wird auf die Zeichnung Bezug genommen, in der eine erfindungsgemäße Stromrichteranordnung schematisch dargestellt ist.
- FIG 1: zeigt einen Aufbau einer Stromrichterschaltung nach dem Stand der Technik, die
- FIG 2: zeigt einen weiteren Aufbau einer Stromrichterschaltung nach dem Stand der Technik, und in
- FIG 3: ist ein Aufbau einer Stromrichteranordnung nach der Erfindung dargestellt.

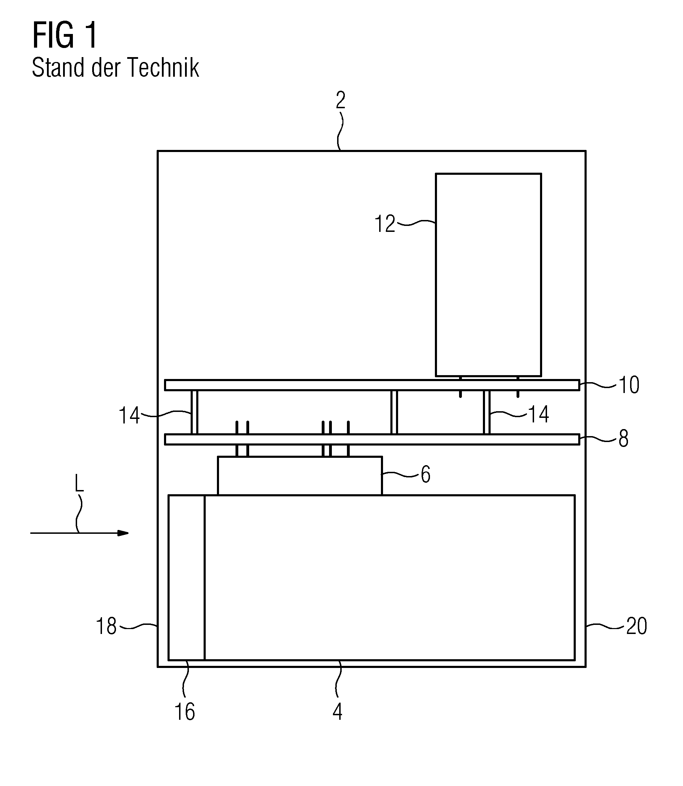

FIG 1 zeigt eine bekannte modular aufgebaute Stromrichteranordnung 2, die einen Kühlkörper 4, wenigstens ein Leistungshalbleitermodul 6, eine Leiterplatte 8 einer Ansteuerbaugruppe, eine Verschienungs-Leiterplatte 10 und Kondensatoren 12 eines Zwischenkreiskondensators aufweist. Von den Kondensatoren 12 ist wegen der Übersichtlichkeit nur ein Kondensator 12 dargestellt. Um einen vorbestimmten Kapazitätswert eines Zwischenkreiskondensators zu realisieren, werden mehrere Kondensatoren 12, insbesondere Elektrolytkondensatoren, elektrisch in Reihe und/oder parallel geschaltet. Die elektrische Verschaltung der mehreren Kondensatoren 12 wird mittels der Verschienungs-Leiterplatte 10 realisiert. Außerdem weist diese Verschienungs-Leiterplatte 10 jeweils eine Lage für eine positive und negative Gleichspannungsschiene und für eine Wechselspannungsschiene auf. Deshalb wird eine Leiterplatte 10 mit mehr als drei Lagen benötigt. Eine derartige Leiterplatte 10 ist auch als Multi-Layer-Leiterplatte bekannt.

Die Leiterplatte 8, mittels der die Signalelektronik der Ansteuerschaltungen der Leistungshalbleiter des Leistungshalbleitermoduls 6 bzw. der Leistungshalbleitermodule 6 verdrahtet wird, weist wegen der Übersichtlichkeit keine Bauelemente der mehreren Ansteuerschaltungen auf. Bei einer dreiphasigen Ausführungsform der Stromrichteranordnung 2 sind sechs Leistungshalbleiter als 6-pulsige Brückenschaltung verschaltet. Jeder Leistungshalbleiter benötigt eine eigene Ansteuerschaltung, so dass auf der Leiterplatte 8 die Bauelemente dieser sechs Ansteuerschaltungen untergebracht und entsprechend verschaltet sind. Diese bestückte Leiterplatte 8 wird als Ansteuerbaugruppe bezeichnet. Jede Ansteuerschaltung muss signaltechnisch mit Steueranschlüssen eines zugeordneten Leistungshalbleiters elektrisch leitend verbunden werden. Dazu ist diese Leiterplatte 8 der Ansteuerbaugruppe direkt auf die Steueranschlüsse der Leistungshalbleiter angeordnet und mit diesen elektrisch leitend verbunden.

Wie bereits erwähnt, werden bei einer dreiphasigen Ausführungsform der Stromrichteranordnung 2 sechs Leistungshalbleiter, insbesondere IGBTs ,benötigt, die als 6-pulsige Brückenschaltung verschaltet werden. Die Leistungshalbleiter, insbesondere die IGBTs, sind im Handel in unterschiedlich ausgeführten Modulen erhältlich. Ein so genanntes Sixpack-Modul weist in einem Modulgehäuse sechs Leistungshalbleiter auf, die als 6-pulsige Brückenschaltung verschaltet sind. Ein so genanntes Halbbrückenmodul, das auch als Dual-Modul bezeichnet wird, weist zwei Leistungshalbleiter auf, die elektrisch in Reihe geschaltet sind. Außerdem sind so genannte Single Module erhältlich, die jeweils nur einen Leistungshalbleiter aufweisen.

Für eine dreiphasige Ausführungsform der Stromrichteranordnung benötigt man entweder ein Sixpack-Modul oder drei Dual-Module oder sechs Single-Module. Für eine Stromrichteranordnung kleiner Leistung wird ein Sixpack-Modul bevorzugt. Steigt die Leistung dieser Stromrichteranordnung 2an, wird das Sixpack-Modul durch drei Dual-Module ersetzt, die dann mit steigender Leistung durch sechs Single-Module ersetzt werden. Abhängig von der Modul-Wahl ist die Entflechtung der Leiterplatte 8 der Ansteuerbaugruppe.

Da die Kondensatoren 12 des Zwischenkreiskondensators mit zugehöriger Verschienungs-Leiterplatte 10 oberhalb der Ansteuerbaugruppe angeordnet ist, müssen die Leistungsanschlüsse DC+, DC- und AC des Leistungshalbleitermoduls 6 über die Leiterplatte 8 mit entsprechenden Stromschienen der Verschienungs-Leiterplatte 10 elektrisch leitend verbunden werden. Dazu sind drei Hochstromkontakte 14 vorgesehen. Jeder Hochstromkontakt 14 verbindet eine Stromschiene der Verschienungs-Leiterplatte 10 mittels einer Leiterbahn der Leiterplatte 8 der Ansteuerbaugruppe mit einem entsprechenden Leistungsanschluss des Leistungshalbleitermoduls 6. Durch die Verwendung dieser Hochstromkontakte 14 wird eine verhältnismäßig große Induktivität in den Kommutierungskreis eingebracht. Außerdem muss die Leiterplatte 8 der Ansteuerbaugruppe neben Leiterbahnen zum Führen von Schwachstrom auch noch Leiterbahnen zum Führen von Starkstrom aufweisen. Von der Höhe des zu führenden Stroms ist die Dicke der Leitbahn und damit von der Kupferbahn der Leiterplatte abhängig. Um mit einer Leiterplatte unterschiedliche Ströme zu führen, muss ein Kompromiss bezüglich der Dicke seines Kupferbelages gefunden werden.

In dieser Ausführung der modular aufgebauten Stromrichteranordnung 2 ist als Kühlung eine forcierte Luftkühlung vorgesehen. Dazu weist die Stromrichteranordnung 2 einen Lüfter 16 auf, der Luft aus der Umgebung der Stromrichteranordnung 2 ansaugt und durch Kühlkanäle des Kühlkörpers 4 treibt. Der Luftstrom, der für die Entwärmung des Leistungshalbleitermoduls 6 bzw. der Leistungshalbleitermodule 6 sorgen soll, ist in dieser Darstellung durch einen Pfeil L gekennzeichnet. Diese Kühlanordnung, bestehend aus Lüfter 16 und Kühlkörper 4, erstreckt sich beispielsweise von Stirnseite 18 zu Stirnseite 20 der Stromrichteranordnung 2. Damit kühlende Luft stirnseitig eintreten und erwärmte Luft stirnseitig austreten kann, sind diese Stirnseiten perforiert.

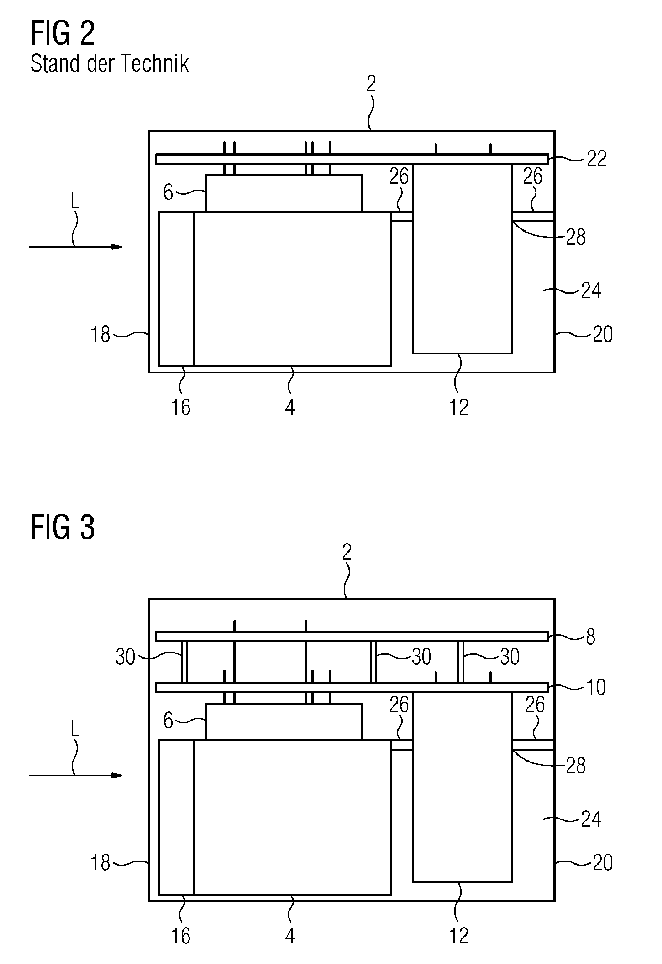

In FIG 2 ist eine weitere Aufbautechnik einer bekannten modular aufgebauten Stromrichteranordnung 2 dargestellt. Diese unterscheidet sich von der Aufbautechnik der FIG 1 dadurch, dass die Leiterplatte 8 der Ansteuerbaugruppe und die Verschienungs-Leiterplatte 10 nun in einer Leiterplatte 22 vereint sind. Außerdem sind die Kondensatoren 12 eines Zwischenkreiskondensators nun derart angeordnet, dass diese in einen gebildeten Kühlkanal 24, der in Stromungsrichtung dem Kühlkörper 4 nachgeschaltet ist, ragen. Dadurch ist dieser Aufbau der Stromrichteranordnung 2 wesentlich kompakter. Für die Bildung des Kühlkanals 24 wird zu den Wänden der Stromrichteranordnung 2 zusätzlich eine Schottwand 26 benötigt, die dafür sorgt, dass die erwärmte Luft sich nicht im Innenraum der Stromrichteranordnung 2 ausbreiten kann, sondern zur perforierten Stirnseite 20 der Stromrichteranordnung 2 geführt wird, wo diese erwärmte Luft an die Umgebung abgegeben wird. Außerdem weist die Schottwand 26 für jeden Kondensator 12 eine Ausnehmung 28 auf. Damit dieser Kanal im Bereich der Ausnehmung 28 zum Innenraum der Stromrichteranordnung 2 dicht ist, besteht diese Schottwand 26 aus einem elastischen Material. Da das Leistungshalbleitermodul 6 eine bestimmte Ausdehnung in der Höhe aufweist, kann nur ein Teil eines jeden Kondensators 12 des Zwischenkreiskondensators, obwohl die Leiterplatte 22 direkt auf die Anschlüsse der Leistungshalbleitermodule 6 angeordnet ist, entwärmt werden. Da nun die Kondensatoren 12 des Zwischenkreiskondensators mit minimalem Abstand zu dem Leistungshalbleitermodul 6 bzw. den Leistungshalbleitermodulen 6 angeordnet werden, ist ein Kommutierungskreis nun sehr niederinduktiv. Das Problem der Störfestigkeit kann mit dieser Aufbautechnik nicht gelöst werden.

In FIG 3 ist eine Aufbautechnik einer erfindungsgemäßen modular aufgebauten Stromrichteranordnung 2 dargestellt. Diese unterscheidet sich von der Aufbautechnik der Stromrichteranordnung 2 in FIG 2 dadurch, dass die Leiterplatte 22 wieder in eine Leiterplatte 8 der Ansteuerbaugruppe und eine Verschienungs-Leiterplatte 10 aufgeteilt ist. Von diesen beiden Leiterplatten 8 und 10 ist die Verschienungs-Leiterplatte 10, an der die Kondensatoren 12 des Zwischenkreiskondensators angeschlossen sind, direkt auf dem Leistungshalbleitermodul 6 bzw. den Leistungshalbleitermodulen 6 angeordnet und direkt mit den Leistungsanschlüssen elektrisch leitend verbunden. Direkt darüber ist die Leiterplatte 8 der Ansteuerbaugruppe angeordnet, deren Steuerausgänge jeweils mit korrespondierenden Steueranschlüssen des Leistungshalbleitermoduls 6 bzw. der Leistungshalbleitermodule 6 elektrisch leitend verbunden sind. Damit die Steueranschlüsse des Leistungshalbleitermoduls 6 bzw. der Leistungshalbleitermodule 6 mit entsprechenden Steuerausgängen der Ansteuerschaltung der Ansteuerbaugruppe elektrisch leitend verbunden werden können, weist die Verschienungs-Leiterplatte 10 entsprechende Durchführungen auf. Damit diese Leiterplatte 8 der Ansteuerbaugruppe einen vorbestimmten Abstand zur Verschienungs-Leiterplatte 10 einhält, sind Distanzstücke 30 vorgesehen. Dadurch werden die elektrischen Verbindungen jeweils zwischen einem Steuerausgang einer Steuerschaltung und einem Steueranschluss des Leistungshalbleitermoduls 6 mechanisch entlastet.

Mit dieser erfindungsgemäßen Aufbautechnik einer modular aufgebauten Stromrichteranordnung wird einerseits der Kommutierungskreis sehr niederinduktiv, wodurch auftretende Überspannungen amplitudenmäßig verringert werden, und andererseits werden die Wege für die Ansteuersignale sehr kurz, so dass sich die Störfestigkeit wesentlich erhöht.

## Patentansprüche

1. Modular aufgebaute Stromrichteranordnung (2) mit einem Kühlkörper (4), mit wenigstens einem Leistungshalbleitermodul (6), die thermisch und mechanisch mit dem Kühlkörper (4) verbunden sind, mit wenigstens einem Kondensator (12) eines Zwischenkreiskondensators, die mittels einer Verschienungs-Leiterplatte (10) untereinander elektrisch leitend verbunden sind, mit einer Ansteuerbaugruppe, bestehend aus Bauelementen wenigstens einer Ansteuerschaltung, die mittels einer Leiterplatte (8) untereinander elektrisch leitend verbunden sind, wobei die Kondensatoren (12) derart fluchtend in Strömungsrichtung eines Kühlkanals (24) dem Kühlkörper (4) nachgeordnet sind, dass die Verschienungs-Leiterplatte (10) direkt oberhalb der Leistungshalbleitermodule (6) angeordnet ist, und wobei die Leiterplatte (8) der Ansteuerbaugruppe oberhalb der Verschienungs-Leiterplatte (10) angeordnet ist, und deren Ausgänge mit Steuereingängen eines Leistungshalbleitermoduls (6) elektrisch leitend verbunden sind.

2. Modular aufgebaute Stromrichteranordnung (2) nach Anspruch 1, **dadurch gekennzeichnet, dass** eine Schottwand (26) mit Ausnehmungen (28) für jeweils einen Kondensator (12) vorgesehen ist, die einen Kühlkanal (24) für ein Kühlmittel zum Innenraum der Stromrichteranordnung (2) abschottet.

3. Modular aufgebaute Stromrichteranordnung (2) nach Anspruch 1, **dadurch gekennzeichnet, dass** an einer Stirnseite des Kühlkörpers (4) ein Lüfter (16) angeordnet ist.

4. Modular aufgebaute Stromrichteranordnung (2) nach Anspruch 1, **dadurch gekennzeichnet, dass** die Verschienungs-Leiterplatte (10) eine Multi-Layer-Leiterplatte ist.

5. Modular aufgebaute Stromrichteranordnung (2) nach Anspruch 2, **dadurch gekennzeichnet, dass** die Schottwand (26) aus einem elastischen Material besteht.

6. Modular aufgebaute Stromrichteranordnung (2) nach Anspruch 1, **dadurch gekennzeichnet, dass** die Verschienungs-Leiterplatte (10) für jeden Steueranschluss eines Leistungshalbleitermoduls (6) eine Durchführung aufweist.

7. Modular aufgebaute Stromrichteranordnung (2) nach Anspruch 1, **dadurch gekennzeichnet, dass** die Verschienungs-Leiterplatte (10) neben zwei Gleichstromlagen wenigstens eine Wechselstromlage aufweist, die gegeneinander elektrisch isoliert sind.

8. Modular aufgebaute Stromrichteranordnung (2) nach Anspruch 1, **dadurch gekennzeichnet, dass** die Leiterplatte (8) der Ansteuerbaugruppe mittels Distanzstücken (30) auf einen vorbestimmten Abstand zur Verschienungs-Leiterplatte (10) angeordnet ist.

9. Modular aufgebaute Stromrichteranordnung (2) nach Anspruch 1, **dadurch gekennzeichnet, dass** das Leistungshalbleitermodul (6) ein Sixpack-Modul ist.

10. Modular aufgebaute Stromrichteranordnung (2) nach Anspruch 1, **dadurch gekennzeichnet,**
**dass** das Leistungshalbleitermodul (6) ein Halbbrücken-Modul ist.

11. Modular aufgebaute Stromrichteranordnung (2) nach Anspruch 1, **dadurch gekennzeichnet,**
**dass** das Leistungshalbleitermodul (6) ein Single-Modul ist.
